# EUROPEAN PATENT APPLICATION

(11) **EP 4 790 697 A1**
(43) Date of publication of application: **12.08.2026**
(21) Application number: 26156807.5
(22) Date of filing: 06.02.2026
(51) Int. Cl.: G09G 3/3266

(54) **DISPLAY DEVICE AND ELECTRONIC DEVICE HAVING THE SAME**

(30) Priority: 11.02.2025 KR 20250017426
(71) Applicant: Samsung Display Co., Ltd., Yongin-si, Gyeonggi-do 17113 (KR)
(72) Inventor: KIM, Su Jin, Giheung-gu, Yongin-si, Gyeonggi-do (KR); KANG, Chul Kyu, Giheung-gu, Yongin-si, Gyeonggi-do (KR); KIM, Dong Hyun, Giheung-gu, Yongin-si, Gyeonggi-do (KR); BYUN, Min Woo, Giheung-gu, Yongin-si, Gyeonggi-do (KR); EOM, Ki Myeong, Gyeonggi-do (KR); OH, Kyong Hwan, Giheung-gu, Yongin-si, Gyeonggi-do (KR); CHEO, Soo Hong, Giheung-gu, Yongin-si, Gyeonggi-do (KR); MOK, Seon Kyoon, Giheung-gu, Yongin-si, Gyeonggi-do (KR); PARK, Bu Young, Giheung-gu, Yongin-si, Gyeonggi-do (KR); LEE, Ga Eun, Giheung-gu, Yongin-si, Gyeonggi-do (KR)
(74) Representative: Dr. Weitzel & Partner

(57) **Abstract**

The present application relate to a display device, and an electronic device including the display device. A display device includes: a display panel including a display area where a plurality of pixels are arranged, and a non-display area outside the display area; a scan driver in the non-display area and including a plurality of stages; and a plurality of clock lines in the non-display area and configured to transmit a clock signal for controlling an operation of the scan driver to the plurality of stages of the scan driver, wherein each of the plurality of clock lines includes: a first sub-clock line; a second sub-clock line which is spaced apart from and arranged in parallel with the first sub-clock line; and at least one connection part configured to electrically partially connect the first sub-clock line and the second sub-clock line.

## Description

The present disclosure relates to a display device, and an electronic device including the display device.

With the development of multimedia, interest in display devices is increasing. For example, interest in the display device such as a liquid crystal display (LCD), an organic light emitting display (OLED), or the like is growing.

The display device may include a display area and a non-display area (or a dead space (DS) area). The display area may include a plurality of pixels, pixel driving circuits, scan lines, data lines and the like. The non-display area may include a data driver, a scan driver, signal lines for transmitting various control signals, clock lines for transmitting clock signals, a power line for supplying power, a ground line and the like.

The clock signal may be transmitted to a corresponding driver (e.g., the scan driver, data driver, etc.) through the clock line as a signal for synchronous processing of various signals (e.g., scan signals, data signals, etc.). However, when the clock line length increases, there may be a problem that a deviation between the signal waveform at a beginning portion and the signal waveform at an end portion of the clock line also increases. As the resistance component (or resistance factor) of the clock line decreases, the deviation between the waveforms may tend to increase. Such deviation between the waveforms may adversely affect the quality of the display device. Therefore, it is desirable to prevent, reduce, or minimize deviations in the waveforms.

The above information disclosed in this Background section is only for enhancement of understanding of the background and therefore the information discussed in this Background section does not necessarily constitute prior art.

Aspects of some embodiments of the present disclosure include a display device that may be capable of preventing or reducing deviations in signal waveforms on clock lines, and an electronic device including the display device.

Aspects of some embodiments of the present disclosure include a display device that have relatively improved quality, and an electronic device including the display device.

The present disclosure is defined by the features of claim 1. The dependent claims and the description provide preferred embodiments.

A display device according to the present disclosure includes a display panel including a display area where a plurality of pixels are arranged, and a non-display area outside the display area; a scan driver in the non-display area and including a plurality of stages; and a plurality of clock lines in the non-display area and configured to transmit a clock signal for controlling an operation of the scan driver to the plurality of stages of the scan driver. Each of the plurality of clock lines includes a first sub-clock line; a second sub-clock line spaced apart from, that is spaced apart with a distance from, and arranged in parallel with the first sub-clock line; and at least one connection part configured to electrically partially connect the first sub-clock line and the second sub-clock line. "Partially connect" especially means that the at least one connection part is not connected along the whole length of the first sub-clock line and the second sub-clock line to the first sub-clock line and the second sub-clock line but only along a restricted section or sections thereof. For example, there may be two or more separate connections parts arranged spaced apart from each other along the length direction of the first sub-clock line and the second sub-clock line.

The at least one connection part may be arranged to form a bridge between the first sub-clock line and the second sub-clock line bridging the distance between the first sub-clock line and the second sub-clock line. The at least one connection part may be arranged to extend perpendicular to or angled to the length directions of the first sub-clock line and the second sub-clock line.

The at least one connection part may be positioned on the first sub-clock line and the second sub-clock line to electrically contact the first sub-clock line and the second sub-clock line. The at least one connection part may be positioned directly on the first sub-clock line and the second sub-clock line to electrically contact the first sub-clock line and the second sub-clock line.

At least one, several or all connection parts may be positioned on the first sub-clock line and the second sub-clock line with a distance in the length direction of the first and second sub-clock lines to the ends of the first sub-clock line and the second sub-clock line.

According to some embodiments, the first sub-clock line and the second sub-clock line may be formed in a double-stacked structure. This means that the first sub-clock line and the second sub-clock line may be stacked in a thickness direction of a substrate of the display panel on which the (sub-) clock lines are arranged.

According to some embodiments, the plurality of clock lines may include a carry clock line configured to transmit a carry clock signal, a global clock line configured to transmit a global clock signal, a scan clock line configured to transmit a scan clock signal, and a sensing clock line configured to transmit a sensing clock signal.

According to some embodiments, the clock line may further include a third sub-clock line spaced apart from and arranged in parallel with the second sub-clock line.

According to some embodiments, the at least one connection part may connect the first, second and third sub-clock lines.

According to some embodiments, the at least one connection part may include a first connection part configured to connect the first sub-clock line and the second sub-clock line; and a second connection part configured to connect the second sub-clock line and the third sub-clock line.

According to some embodiments, the at least one connection part may include a first connection part configured to connect the first sub-clock line and the second sub-clock line or the second sub-clock line and the third sub-clock line; and a second connection part configured to connect the first sub-clock line and the second sub-clock line and the third sub-clock line.

According to some embodiments, the at least one connection part includes a plurality of connection parts, lengths and widths of the plurality of connection parts may be equal (or substantially equal) or different from each other.

According to some embodiments, the plurality of clock lines may be repeatedly connected to a designated number of consecutive stages of the plurality of stages.

According to some embodiments, a length of the at least one connection part may be equal (or substantially equal) to a length of one of the consecutive stages.

An electronic device according to some embodiments of the present disclosure includes a display device; and a processor connected to the display device and configured to control an operation of the display device. The display device includes a display panel including a display area where a plurality of pixels are arranged, and a non-display area outside the display area; a scan driver in the non-display area and including a plurality of stages; and a plurality of clock lines formed in the non-display area and configured to transmit a clock signal for controlling an operation of the scan driver to the plurality of stages of the scan driver. Each of the plurality of clock lines includes a first sub-clock line; a second sub-clock line spaced apart from and arranged in parallel with the first sub-clock line; and at least one connection part configured to electrically partially connect the first sub-clock line and the second sub-clock line.

The above and other aspects, features and other characteristics of some embodiments of the present disclosure will be more clearly understood from the following detailed description taken in conjunction with the accompanying drawings, in which:
FIG. 1A is a perspective view illustrating a display device according to some embodiments;
FIG. 1B is a plan view illustrating the display device according to some embodiments;
FIG. 2 is a view schematically illustrating a scan driver of the display device according to some embodiments;
FIG. 3 is a detail view illustrating aspects of an area A of FIG. 2;
FIG. 4 is a detailed view illustrating aspects of an area B of FIG. 2;
FIG. 5 is a view illustrating a clock line having a double-stacked structure according to some embodiments;
FIG. 6 is a view illustrating clock lines having various structures according to some embodiments;
FIG. 7 is a block diagram of an electronic device according to some embodiments; and
FIG. 8 is a schematic view illustrating different applications of the electronic device according to some embodiments.

Hereinafter, aspects of some embodiments of the present disclosure will be described in more detail with reference to the accompanying drawings. Specific embodiments of the present disclosure will be illustrated in the drawings and described in the following detailed description related thereto, but it is not intended to limit the various embodiments of the present disclosure to a specific form. For example, it is obvious to those skilled art to which the present disclosure pertains that the embodiments of the present disclosure may be variously modified.

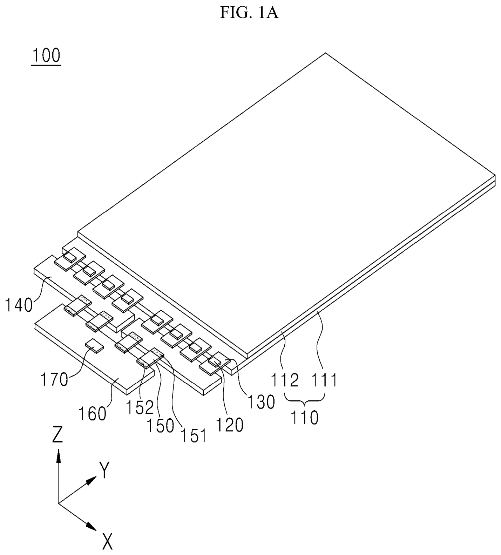

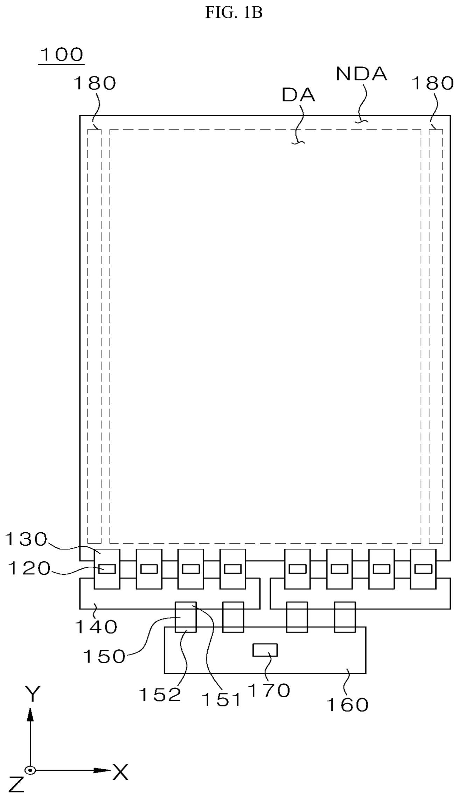

FIG. 1A is a perspective view illustrating a display device according to some embodiments, and FIG. 1B is a plan view illustrating the display device according to some embodiments.

Prior to the detailed description, in the present disclosure, "upper portion," "top," and "upper surface" refer to an upper direction, that is, a Z-axis direction, based on a display panel 110, and "lower portion," "bottom," and "lower surface" refer to a lower direction, that is, the direction opposite to the Z-axis direction, based on the display panel 110. Additionally, "upper side," "lower side," "left side," and "right side" indicate directions when viewing the display panel 110 on a plan. For example, the "upper side" corresponds to a Y-axis direction, the "lower side" corresponds to the direction opposite to the Y-axis direction, the "left side" corresponds to the direction opposite to an X-axis direction, and the "right side" corresponds to the X-axis direction.

In the present disclosure, a display device 100 according to some embodiments of the present disclosure is a device that displays moving (e.g., video) or still (e.g., static) images, and may serve as a display screen of various products, such as portable electronic devices including a mobile phone, a smartphone, a tablet personal computer (PC), a smart watch, a watch phone, a mobile communication terminal, an electronic notebook, an electronic book, a portable multimedia player (PMP), a navigation device, an ultra-mobile PC (UMPC), etc., as well as a multimedia device installed in, embedded in, or integrally formed with an automobile (e.g., a display for a vehicle, a head-up display, etc.), or a home appliance (e.g., a television, etc.), a laptop, a monitor, a billboard, and Internet of Things (IOT) devices. In addition, the display device 100 according to some embodiments of the present disclosure may be included in various types of electronic devices. For example, the display device 100 according to some embodiments of the present disclosure may be incorporated into a rigid, flexible, foldable, rollable, or wearable type electronic device.

Hereinafter, the display device 100 according to some embodiments is illustrated and described as a medium- to large-sized display device including a plurality of data drivers 120, but embodiments according to the present disclosure are not limited thereto. The display device 100 according to some embodiments may be a small-sized display device including one data driver 120. In this case, flexible films 130, source circuit boards 140 and connection members 150 may be omitted. In addition, when the display device 100 according to some embodiments is the small-sized display device, the data driver 120 and a timing controller 170 may be integrated into one integrated circuit and placed on one circuit board, or may be adhered to a first substrate 111 of the display panel 110. Examples of the medium- to large-sized display devices include televisions and monitors, etc., and examples of the small-sized display devices include smartphones and tablet PCs, etc.

Referring to FIGS. 1A and 1B, the display device 100 according to some embodiments may include the display panel 110, the data drivers 120, the flexible films 130, the source circuit board 140, the connection members 150, a control circuit board 160, the timing controller 170, and a scan driver 180.

The display panel 110 may be formed in a rectangular shape. For example, the display panel 110 may have a rectangular shape with a short side in a first direction (the X-axis direction) and a long side in a second direction (the Y-axis direction), as shown in FIG. 1B. Corners of the display panel 110 may be formed at a right angle or rounded with a curvature (e.g., a set or predetermined curvature). The flat shape of the display panel 110 is not limited to the rectangle, and may be formed in other polygonal, circular or oval shapes. In addition, although FIGS. 1A and 1B illustrate that the display panel 110 is formed flat, but embodiments according to the present disclosure are not limited thereto. The display panel 110 may include a curved portion bent at a curvature (e.g., a set or predetermined curvature).

According to some embodiments, the display panel 110 may include the first substrate 111 and a second substrate 112. The second substrate 112 may be arranged to face a first surface of the first substrate 111. The first substrate 111 and the second substrate 112 may be formed as a rigid or flexible substrate. The first substrate 111 may be made of glass or plastic. The second substrate 112 may be made of glass, plastic, a sealing film, or a barrier film. Alternatively, the second substrate 112 may be omitted.

According to some embodiments, the display panel 110 may be an organic light-emitting display panel using an organic light-emitting diode, a quantum dot light-emitting display panel which includes a quantum dot light-emitting layer, an inorganic light-emitting display panel including an inorganic semiconductor, or an ultra-small light-emitting display panel using a micro light emitting diode (LED). Hereinafter, for convenience of description, an example where the display panel 110 is an organic light-emitting display panel will be described.

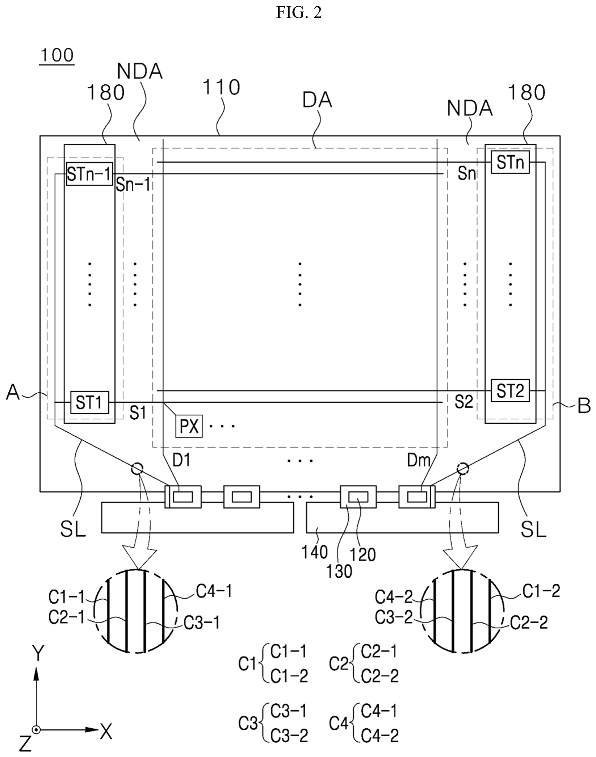

The display panel 110 may include a display area DA where pixels (e.g., pixels PX in FIG. 2, described below) are formed to display an image, and a non-display area NDA, which is a peripheral region surrounding (e.g., in a periphery or outside a footprint of) the display area DA.

In the display area DA, not only pixels but also scan signal lines, data lines, and driving voltage lines connected to the pixels may be arranged. The scan signal lines may be arranged in the first direction (X-axis direction) within the display area DA. The data lines may be arranged in the second direction (Y-axis direction) intersecting (e.g., vertically intersecting) the first direction (X-axis direction) within the display area DA. The driving voltage lines may be arranged in the second direction (Y-axis direction) within the display area DA.

The non-display area NDA may be defined as an area from the outer boundary of the display area DA to the edge of the display panel 110. For example, the non-display area NDA may surround the display area DA and be positioned at the periphery of the display panel 110, but embodiments according to the present disclosure are not limited thereto. The scan driver 180, which includes a plurality of stages (e.g., plurality of stages ST1 to STn in FIG. 2, described below) that sequentially output scan signals, may be located in the non-display area NDA.

The scan driver 180 may be connected to the flexible films 130 through a plurality of scan control lines (e.g., scan control line SL in FIG. 2). The scan driver 180 may receive a scan control signal from the timing controller 170 through the plurality of scan control lines. The scan control signal may include a plurality of clock signals, a gate-on voltage, and a gate-off voltage. The scan driver 180 may generate a scan signal based on the scan control signal, and output the generated scan signal through the scan signal line. The scan driver 180 will be described in more detail below with reference to FIGS. 2 to 4.

Meanwhile, FIG. 1B illustrates an example where the scan driver 180 is formed in the non-display area NDA on both sides of the display area DA, such as the left and right sides of the display area DA, but embodiments according to the present disclosure are not limited thereto. For example, the scan driver 180 may be formed in the non-display area NDA on only one side, such as the left or right side of the display area DA.

The flexible film 130 may have one side attached to the first surface of the first substrate 111 of the display panel 110, and the other side attached to one surface of the source circuit board 140. For example, because the size of the second substrate 112 is smaller than the size of the first substrate 111, one side of the first substrate 111 may be exposed without being covered by the second substrate 112. The flexible film 130 may be attached to the one side of the first substrate 111 which is exposed without being covered by the second substrate 112. For example, the flexible film 130 may be attached to the first surface of the first substrate 111 and the one surface of the source circuit board 140 using an anisotropic conductive film, but embodiments according to the present disclosure are not limited thereto.

According to some embodiments, the flexible film 130 may be a flexible film such as a tape carrier package or a chip on film (COF). The flexible film 130 may be bent toward a lower portion of the first substrate 111. When the flexible films 130 are bent toward the lower portion of the first substrate 111, the source circuit board 140, the connection members 150, and the control circuit board 160 may be located on a lower surface of the display panel 110. Although FIGS. 1A and 1B illustrate an example where eight flexible films 130 are attached to the first substrate 111 of the display panel 110, the number of flexible films 130 is not limited to eight.

The data driver 120 may be located on one surface of the flexible film 130. The data driver 120 may be formed as an integrated circuit (IC). The data driver 120 may convert digital video data (DATA) into analog data voltages based on a data control signal of the timing controller 170 and supply the voltages to a data line of the display panel 110 through the flexible film 130.

The source circuit board 140 may be connected to the control circuit board 160 through the connection member 150. The source circuit board 140 may include a first connector 151 to which one side of the connection member 150 is connected (e.g., inserted). The source circuit board 140 may be a flexible printed circuit board (FPCB) or a printed circuit board (PCB).

The connection member 150 may connect the source circuit board 140 and the control circuit board 160. The connection member 150 may be a flexible cable, but embodiments according to the present disclosure are not limited thereto.

The control circuit board 160 may be connected to the source circuit board 140 through the connection member 150. The control circuit board 160 may include a second connector 152 to which the other side of the connection member 150 is connected (e.g., inserted). The control circuit board 160 may be a flexible printed circuit board or a printed circuit board.

Meanwhile, FIGS. 1A and 1B illustrate an example where the source circuit board 140 and the control circuit board 160 are connected by four connection members 150, but the number of connection members 150 is not limited to four. In addition, FIGS. 1A and 1B illustrate an example including two source circuit boards 140, but the number of source circuit boards 140 is not limited to two. Further, when the number of flexible films 130 is small, the source circuit board 140 may be omitted. When the source circuit board 140 is omitted, the connection member 150, the first connector 151, and the second connector 152 are also omitted, and in this case, the flexible film 130 may be directly connected to the control circuit board 160.

The timing controller 170 may be located on one surface of the control circuit board 160. The timing controller 170 may be formed as an integrated circuit.

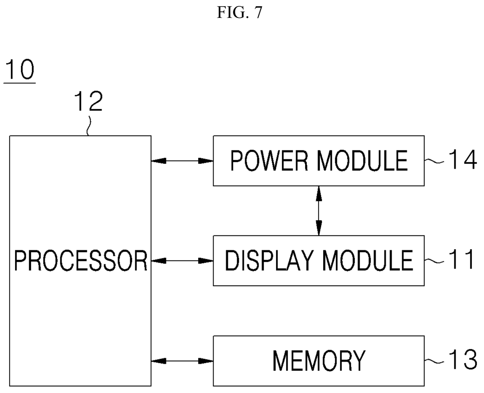

According to some embodiments, the timing controller 170 may receive digital video data and timing signals from a processor (such as a central processing unit (CPU), an application processor (AP), a graphic processing unit (GPU)) of a main circuit board of an electronic device (e.g., an electronic device 10 of FIG. 7). The timing controller 170 may generate a source control signal for controlling timing of the data driver 120 and a scan control signal for controlling timing of the scan driver 180 based on the timing signals. The timing controller 170 may output a scan control signal (e.g., a clock signal) to the scan driver 180, and transmit the digital video data (DATA) along with the source control signal to the data driver 120. According to some embodiments, the timing controller 170 may include a clock generation circuit.

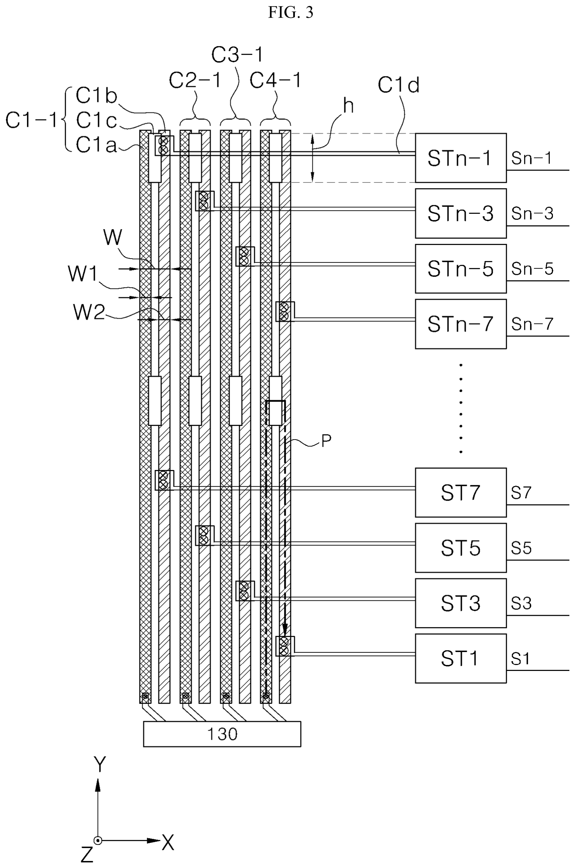

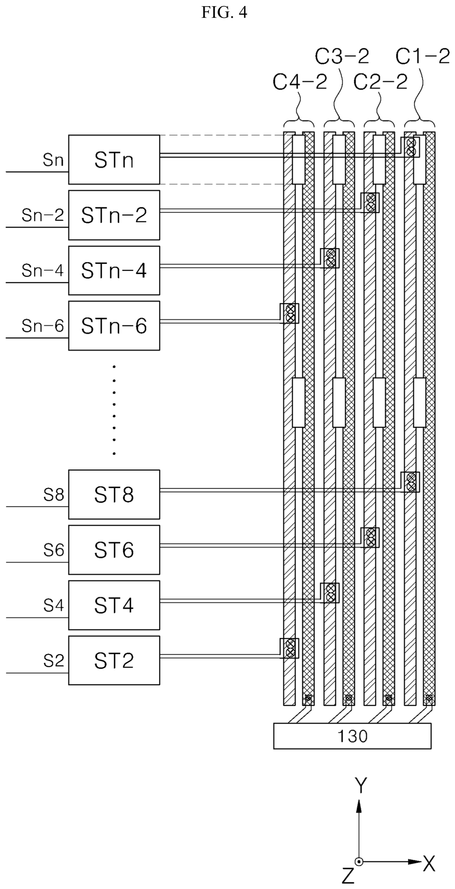

FIG. 2 is a view schematically illustrating a scan driver of the display device according to some embodiments, FIG. 3 is a detail view illustrating an area A of FIG. 2, and FIG. 4 is a detailed view illustrating an area B of FIG. 2.

Referring to FIGS. 2, 3 and 4, the scan driver 180 of the display device 100 according to some embodiments is positioned in the non-display area NDA, and may provide (or apply) scan signals to a plurality of pixels PX arranged in multiple rows and columns (e.g., n X m, where n and m are natural numbers that are greater than 0) within the display area DA through scan signal lines S1 to Sn. For example, one scan signal may be provided to the plurality of pixels PX positioned in the same row. Similarly, the data driver 120 may provide (or apply) data signals to the plurality of pixels PX arranged in multiple rows and columns (e.g., n X m, where n and m are natural numbers that are greater than 0) within the display area DA through data lines D1 to Dm. For example, one data signal may be provided to the plurality of pixels PX positioned in the same column. The scan signal lines S1 to Sn and the data lines D1 to Dm are connected to the pixels PX, and may intersect while remaining insulated from each other in the display area DA.

The scan driver 180 may generate a scan signal based on a scan control signal, and provide the generated scan signal to each pixel PX through the scan signal lines S1 to Sn. The scan driver 180 may include a plurality of stages ST1 to STn. The scan signal lines S1 to Sn may be connected to output terminals of the plurality of stages ST1 to STn, respectively. For example, first, second, third, fourth, fifth, sixth, seventh, eighth, n-7th, n-6th, n-5th, n-4th, n-3th, n-2th, n-1th and nth scan signal lines S1, S2, S3, S4, S5, S6, S7, S8, Sn-7, Sn-6, Sn-5, Sn-4, Sn-3, Sn-2, Sn-1 and Sn may be connected to first, second, third, fourth, fifth, sixth, seventh, eighth, n-7th, n-6th, n-5th, n-4th, n-3th, n-2th, n-1th and nth stages ST1, ST2, ST3, ST4, ST5, ST6, ST7, ST8, STn-7, STn-6, STn-5, STn-4, STn-3, STn-2, STn-1 and STn, respectively.

The scan driver 180 may be connected to the flexible film 130 through the scan control line SL. The scan driver 180 may receive a scan control signal from the timing controller 170 through the scan control line SL. The scan control signal may include a clock signal and a control signal. Meanwhile, although the scan control line SL is illustrated as a single line in FIG. 2, the scan control line SL may include a plurality of lines. For example, the scan control line SL may include a plurality of clock lines configured to transmit clock signals, as illustrated in FIGS. 2, 3 and 4. For example, the clock lines may include a carry clock line for transmitting a carry clock signal, a global clock line for transmitting a global clock signal, a scan clock line for transmitting a scan clock signal, and a sensing clock line for transmitting a sensing clock signal, but they are not limited thereto.

The plurality of clock lines include first to fourth clock lines C1-C4, and the first to fourth clock lines C1-C4 may extend from a lower end to an upper end of the display device 100, running parallel to each other except in some areas. Meanwhile, the scan drivers 180 are separately arranged on the left and right sides of the display device 100. Accordingly, the first clock line C1 is divided into a first-1 clock line C1-1 and a first-2 clock line C1-2, the second clock line C2 is divided into a second-1 clock line C2-1 and a second-2 clock line C2-2, the third clock line C3 is divided into a third-1 clock line C3-1 and a third-2 clock line C3-2, and the fourth clock line C4 is divided into a fourth-1 clock line C4-1 and a fourth-2 clock line C4-2, as will be described below.

According to some embodiments, each clock line may include a plurality of lines. For example, the first-1 clock line C1-1 may include a first sub-clock line C1a, a second sub-clock line C1b arranged parallel with and spaced apart from the first sub-clock line C1a, and at least one connection part C1c which electrically connects the first sub-clock line C1a and the second sub-clock line C1b at at least one point. Here, a size (hereinafter, a width) W1 of the first sub-clock line C1a in the first direction (X-axis direction) and a width W2 of the second sub-clock line C1b in the first direction (X-axis direction) may be equal to (or substantially equal to) or different from each other. In addition, the overall width W of the first-1 clock line C1-1 in the first direction (X-axis) may be equal (or substantially equal) to the width of the conventional clock lines. As used herein, "substantially equal" means that the sizes are either exactly identical or nearly similar to each other, even if they are not perfectly identical.

The second sub-clock line C1b may be electrically connected to the scan driver 180 through a connection line C1d. The size (or length) h of the at least one connection part C1c in the second direction (Y-axis) may be equal (or substantially equal) to the size of one stage in the second direction.

The stages ST1-STn may be connected to the first to fourth clock lines C1-C4 in a repeating cycle of a number (e.g., a set or predetermined number) (e.g., four) of consecutive stages to receive clock signals. For example, a first stage ST1 and an n-7th stage STn-7 may be connected to the fourth-1 clock line C4-1, a third stage ST3 and an n-5th stage STn-5 may be connected to the third-1 clock line C3-1, a fifth stage ST5 and an n-3th stage STn-3 may be connected to the second-1 clock line C2-1, and a seventh stage ST7 and an n-1th stage STn-1 may be connected to the first-1 clock line C1-1. In addition, a second stage ST2 and an n-6th stage STn-6 may be connected to the fourth-2 clock line C4-2, a fourth stage ST4 and an n-4th stage STn-4 may be connected to the third-2 clock line C3-2, a sixth stage ST6 and an n-2th stage STn-2 may be connected to the second-2 clock line C2-2, and an eighth stage ST8 and an nth stage STn may be connected to the first-2 clock line C1-2.

Meanwhile, although it is shown above that the scan driver 180 uses four clock signals, the number of the clock signals may be fewer or greater than four. For example, the number of clock signals may be two, six, eight, or more.

The above-described embodiments of the present disclosure may divide one clock line into two sub-lines and connect them at at least one point. As a result, the embodiments of the present disclosure may have the effect of increasing the resistance of the clock line, as the widths W1 and W2 of the lines through which the clock signal moves are reduced and the movement path (or movement length) p of the clock signal becomes longer compared to the conventional clock lines. As a result, the display device 100 according to some embodiments of the present disclosure may prevent (or reduce or minimize) deviation generation between waveforms at beginning and end portions of each clock line.

Meanwhile, although it is illustrated and described above that the two scan drivers 180 of the display device 100 are positioned on the left and right sides of the non-display area NDA, one scan driver may be instead positioned on either the left or right side of the non-display area NDA. In addition, the display device 100 may further include a gate driver and/or a pixel driver. In this case, the display device 100 may have the scan driver positioned on the left (or right) side, while the gate driver or the pixel driver positioned on the right (or left) side.

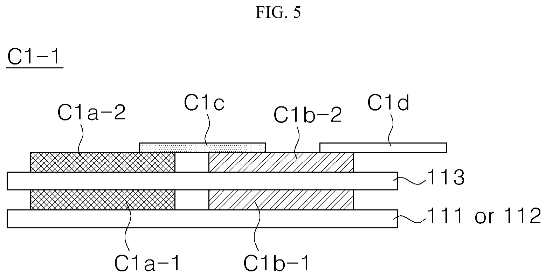

FIG. 5 is a view illustrating a clock line having a double-stacked structure according to some embodiments.

Referring to FIG. 5, the clock line according to some embodiments may have a double-stacked structure. Hereinafter, the first-1 clock line C1-1 will be described as an example.

A first-1 sub-clock line C1a-1 and a second-1 sub-clock line C1b-1 are positioned on the substrate 111 or 112 that may be made of an insulation material such as glass or plastic. An insulation layer 113 is positioned on the upper surfaces of the first-1 sub-clock line C1a-1 and the second-1 sub-clock line C1b-1, and a first-2 sub-clock line C1a-2 and a second-2 sub-clock line C1b-2 are positioned on the upper surface of the insulation layer 113. A connection part C1c and a connection line C1d are positioned on the upper surfaces of the first-2 sub-clock line C1a-2 and the second-2 sub-clock line C1b-2.

Meanwhile, according to some embodiments, the first-1 sub-clock line C1a-1 and the first-2 sub-clock line C1a-2 may be connected through a first contact hole (e.g., a via hole), and the second-1 sub-clock line C1b-1 and the second-2 sub-clock line C1b-2 may be connected through a second contact hole (e.g., another via hole). The first sub-clock line C1a and the second sub-clock line C1b may have a double-stacked structure.

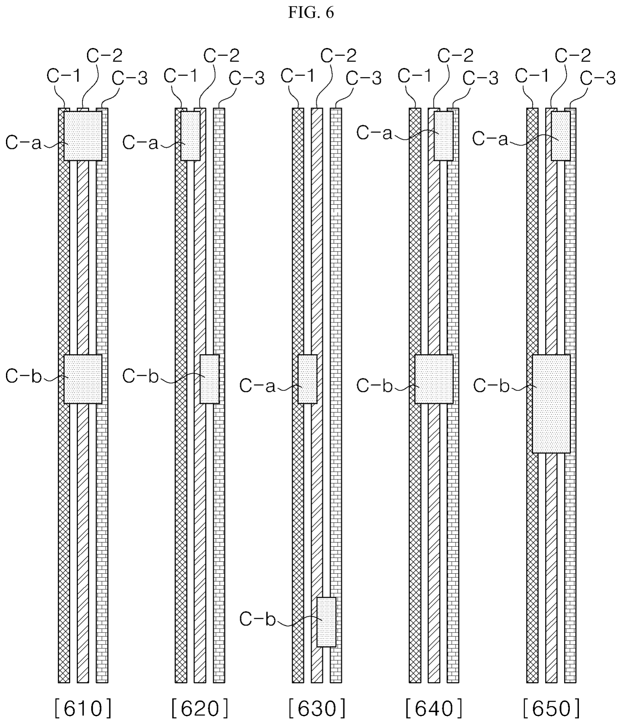

FIG. 6 is a view illustrating clock lines having various structures according to some embodiments.

Referring to FIG. 6, each clock line according to some embodiments may include three sub-clock lines C-1, C-2 and C-3. In addition, at least one of the positions, sizes, and lengths of the connection potions which connect the respective sub-clock lines may vary. For example, a first connection part C-a and a second connection part C-b may connect a first sub-clock line C-1, a second sub-clock line C-2 and a third sub-clock line C-3, as shown in FIG. 6 with an identification symbol 610.

As another example, as shown in FIG. 6 with an identification symbol 620, the first connection part C-a may connect the first sub-clock line C-1 and the second sub-clock line C-2, while the second connection part C-b may connect the second sub-clock line C-2 and the third sub-clock line C-3.

As another example, as shown in FIG. 6 with an identification symbol 630, the first connection part C-a may connect the first sub-clock line C-1 and the second sub-clock line C-2 at a middle portion of the clock line, while the second connection part C-b may connect the second sub-clock line C-2 and the third sub-clock line C-3 at a bottom portion of the clock line.

As another example, as shown in FIG. 6 with an identification symbol 640, the first connection part C-a may connect the first sub-clock line C-1 and second sub-clock line C-2 or connect the second sub-clock line C-2 and the third sub-clock line C-3, while the second connection part C-b may connect the first sub-clock line C-1, second sub-clock line C-2 and third sub-clock line C-3.

As another example, as shown in FIG. 6 with an identification symbol 650, the length of the first connection part C-a and the length of the second connection part C-b may be different from each other.

Meanwhile, the examples of FIG. 6 are merely illustrative, and do not limit the present disclosure, as various combinations may be possible. In addition, each clock line may include four or more sub-clock lines. Furthermore, each clock line may include three or more connection parts.

The display device 100 according to the embodiments may be applied to various electronic devices. The electronic device according to some embodiments includes the above-described display device 100, and may further include a module or device with additional functions in addition to the display device.

FIG. 7 is a block diagram of an electronic device according to some embodiments.

Referring to FIG. 7, the electronic device 10 according to some embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for an operation of the processor 12 or the display module 11. When the processor 12 executes an application stored in the memory 13, an image data signal and/or an input control signal may be transmitted to the display module 11, and then, the display module 11 may process the received signal and output image information through the display screen.

The power module 14 may include a power supply module such as a power adapter or a battery device, and a power conversion module that converts power supplied by the power supply module to generate power necessary for an operation of the electronic device 10.

At least one of the above-described components of the electronic device 10 may be included in the display device 100 according to the embodiments described above. In addition, some parts of individual modules functionally integrated in one module may be included in the display device 100, while other parts may be provided separately from the display device 100. For example, the display device 100 may include the display module 11, whereas the processor 12, memory 13 and power module 14 may be provided as parts of another device within the electronic device 10 rather than the display device 100.

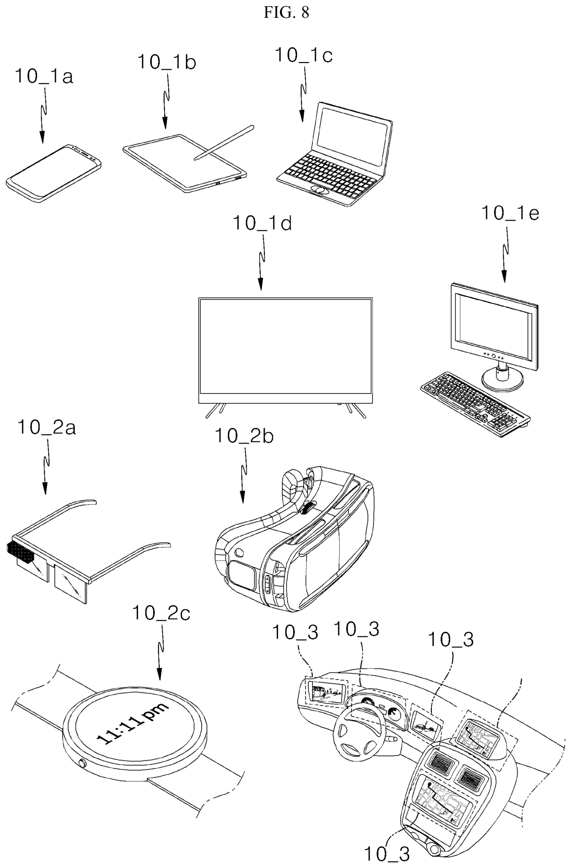

FIG. 8 is a schematic view illustrating different applications of the electronic device according to various embodiments.

Referring to FIG. 8, various electronic devices to which the display device according to the embodiments is applied may include not only image display electronic devices such as a smartphone 10_1a, a tablet PC 10_1b, a laptop 10_1c, a TV 10_1d, a desktop monitor 10_1e, etc., but also wearable electronic devices including a display module such as smart glasses 10_2a, a head-mounted display 10_2b, a smart watch 10_2c, etc., and vehicle electronic devices 10_3 including display modules such as a center information display (CID) arranged on an instrument panel, center fascia, or dashboard of a vehicle, and a room mirror display.

Various embodiments of the present disclosure may prevent or reduce deviations in signal waveforms on clock lines. In other words, various embodiments of the present disclosure may provide a clock signal without deviation. As a result, various embodiments of the present disclosure may improve the quality of the display device (e.g., uniformity of image quality).

Various embodiments of the present disclosure and the terms used herein do not limit the technical characteristics described in the present disclosure to specific embodiments. With regard to the description of the drawings, similar or related components may be denoted by similar reference numerals. It is to be understood that a singular form of a noun corresponding to an item may include one or a plurality of the things, unless the relevant context clearly indicates otherwise. As used herein, each of phrases such as "A or B," "at least one of A and B," "A, B or C," and "at least one of A, B and C" may include any one, or all possible combinations of these items enumerated together in the corresponding one of the phrases. As used herein, the terms such as "1st" and "2nd," or "first" and "second" may be used to simply distinguish the corresponding component from another component, and does not limit the corresponding components in other aspects (e.g., an importance or order). It is to be understood that if a component (e.g., a first component) is referred to as "bonded to" or "connected to" another component (e.g., a second component), with or without the term "operatively" or "communicatively," it means that the component may be bonded to the other component directly (e.g., by wire), wirelessly, or through a third component.

The term "module" used in various embodiments of the present disclosure may include a unit implemented in hardware, software or firmware way, and for example, may be used interchangeably with the terms such as logic, a logic block, a part, or a circuit. The module may be a part integrally formed therewith, or a minimum unit of the part or a portion thereof which performs one or more functions. For example, according to some embodiments, the module may be implemented in a form of an application-specific integrated circuit (ASIC).

Various embodiments of the present disclosure may be implemented by software (e.g., a program) including one or more instructions stored in a storage medium (e.g., an internal memory or an external memory) readable by a machine (e.g., an electronic device 10). For example, a processor of the machine (e.g., the electronic device 10) may call, among one or more instructions stored in the storage medium, at least one instruction, and may execute the instruction. This allows at least one function to be performed according to the called at least one instruction. The one or more instructions may include a code that is made by a compiler or a code that may be executed by an interpreter. The storage medium that may be read by a device may be provided in a form of a non-transitory storage medium. Here, the 'non-transitory storage medium' means that the storage medium is a tangible device and does not include a signal (e.g., an electromagnetic wave), and with regard to the term, a case, in which data are semi-permanently stored in the storage medium, and a case, in which data are temporarily stored in the storage medium, are not distinguished.

According to some embodiments, the methods according to various embodiments of the present disclosure may be provided to be included in a computer program product. The computer program product may be traded between a seller and a purchaser. The computer program product may be distributed in a form of a storage medium that may be read by a device (e.g., a compact disk read only memory (CD-ROM)) or may be distributed (e.g., downloaded or uploaded) through an application store or directly or online between two user devices. In the online distribution, at least a portion of the computer program product may be at least temporarily stored in a storage medium, such as a server of a manufacturer, a server of an application store, or a memory of a relay server, which may be read by a device, or temporarily generated.

According to various embodiments, each component or element (e.g., a module or program) of the above-described components or elements may include one or a plurality of entities or sub-components. According to various embodiments, among the above-described components, one or more components or operations thereof may be omitted or one or more other components or operations thereof may be added to the components. Alternatively or additionally, the plurality of components (e.g., the modules or programs) may be integrated into one component. In this case, the integrated components may perform one or more functions of each component of the plurality of components in a way that they are the same as or similar to the functions performed by the corresponding components among the plurality of components before the integration. According to various embodiments, operations performed by the modules, programs, or other components may be executed sequentially, in parallel, repeatedly, or heuristically, one or more operations may be executed in another sequence or omitted, or one or more other operations may be added thereto.

## Claims

1. A display device (100) comprising:
a display panel (110) including a display area (DA) where a plurality of pixels (PX) are arranged, and a non-display area (NDA) outside the display area (DA);
a scan driver (180) in the non-display area (NDA) and including a plurality of stages (ST1-STn); and
a plurality of clock lines (C1-C4) in the non-display area (NDA) and configured to transmit a clock signal for controlling an operation of the scan driver (180) to the plurality of stages (ST1-STn) of the scan driver (180),
wherein each of the plurality of clock lines (C1-C4) comprises:
a first sub-clock line (C1a, C1);
a second sub-clock line (C1b, C2) which is spaced apart from and arranged in parallel with the first sub-clock line (C1a, C1); and
at least one connection part (C1c, C-a, C-b) configured to electrically partially connect the first sub-clock line (C1a, C1) and the second sub-clock line (C1b, C2).

2. The display device (100) according to claim 1, wherein the first sub-clock line (C1a, C1) and the second sub-clock line (C1b, C2) have a double-stacked structure.

3. The display device (100) according to claim 1 or 2, wherein the plurality of clock lines (C1-C4) comprises a carry clock line configured to transmit a carry clock signal, a global clock line configured to transmit a global clock signal, a scan clock line configured to transmit a scan clock signal, and a sensing clock line configured to transmit a sensing clock signal.

4. The display device (100) according to at least one of claims 1 to 3, wherein the clock line (C1-C4) further comprises a third sub-clock line (C-3) spaced apart from and arranged in parallel with the second sub-clock line (C1b, C2).

5. The display device (100) according to claim 4, wherein the at least one connection part (C-a, C-b) connects the first, second and third sub-clock lines (C1, C-2, C-3).

6. The display device (100) according to claim 4, wherein the at least one connection part (C-a, C-b) comprises:
a first connection part (C-a) configured to connect the first sub-clock line (C1a, C1) and the second sub-clock line (C1b, C2); and
a second connection part (C-b) configured to connect the second sub-clock line (C1b, C2) and the third sub-clock line (C-3).

7. The display device (100) according to claim 4, wherein the at least one connection part (C-a, C-b) comprises:
a first connection part (C-a) configured to connect the first sub-clock line (C1a, C1) and the second sub-clock line (C1b, C2) or the second sub-clock line (C1b, C2) and the third sub-clock line (C-3); and
a second connection part (C-b) configured to connect the first sub-clock line (C1a, C1), the second sub-clock line (C1b, C2) and the third sub-clock line (C-3).

8. The display device (100) according to at least one of claims 1 to 7, wherein the at least one connection part (C1c, C-a, C-b) includes a plurality of connection parts (C1c, C-a, C-b), and
lengths of the plurality of connection parts (C1c, C-a, C-b) are equal to each other.

9. The display device (100) according to at least one of claims 1 to 7, wherein the at least one connection part (C1c, C-a, C-b) includes a plurality of connection parts (C1c, C-a, C-b), and
lengths of the plurality of connection parts (C1c, C-a, C-b) are different from each other.

10. The display device (100) according to at least one of claims 1 to 7, wherein the at least one connection part (C1c, C-a, C-b) includes a plurality of connection parts (C1c, C-a, C-b), and
widths of the plurality of connection parts (C1c, C-a, C-b) are equal to each other.

11. The display device (100) according to at least one of claims 1 to 7, wherein the at least one connection part (C1c, C-a, C-b) includes a plurality of connection parts (C1c, C-a, C-b), and
widths of the plurality of connection parts (C1c, C-a, C-b) are different from each other.

12. The display device (100) according to at least one of claims 1 to 11, wherein the plurality of clock lines (C1-C4) are repeatedly connected to a designated number of consecutive stages (ST1-STn) of the plurality of stages (ST1-STn).

13. The display device (100) according to claim 12, wherein a length of the at least one connection part (C1c, C-a, C-b) is equal to a length of one of the consecutive stages (ST1-STn).

14. The display device (100) according to at least one of claims 1 to 13, wherein the at least one connection part (C1c, C-a, C-b) is arranged to form a bridge between the first sub-clock line (C1a, C1) and the second sub-clock line (C1b, C2) bridging the distance between the first sub-clock line (C1a, C1) and the second sub-clock line (C1b, C2).

15. An electronic device (10) comprising:
a display device (100) according to at least one of claims 1 to 14; and
a processor (12) connected to the display device (100) and configured to control an operation of the display device (100).
